# EUROPÄISCHE PATENTANMELDUNG

(11) **EP 1 833 088 A1**
(43) Veröffentlichungstag der Anmeldung: **12.09.2007**
(21) Anmeldenummer: 06004615.8
(22) Anmeldetag: 07.03.2006
(51) Int. Cl.: H01L 23/373, H05K 1/05

(54) **Verfahren zur Erstellung einer rissarmer Verbindung zwischen einer Wärmesenke und einer Substratplatte**

(71) Anmelder: Danfoss Silicon Power GmbH, 24837 Schleswig (DE)
(72) Erfinder: Kock, Mathias, 25557 Gokels (DE); Eisele, Ronald, 24229 Surendorf (DE)
(74) Vertreter: Biehl, Christian

(57) **Zusammenfassung**

Verfahren zum Erstellen einer rißarmen, temperaturwechselfesten Verbindung zwischen zwei Verbindungspartnern unterschiedlicher thermischen Ausdehnungskoeffizienten nämlich Leistungshalbleitersubstraten und Wärmesenkenplatten mit einer in einem Strom heißen Gases aufgespritzten Schicht, wobei das Aufspritzen von eine Verbindungsschicht bildendenden Partikeln auf wenigstens Teilbereiche des zur Verbindung bestimmten Gebietes auf wenigstens einen der Verbindungspartner unter Ausbildung wenigstens einer innig mit dem einen Verbindungspartner verbunden Schicht erfolgt, wobei das Schichtmaterial einen vorbestimmten thermischen Ausdehnungskoeffizienten erhält, der zwischen den thermischen Ausdehnungskoeffizienten der Verbindungspartner gewählt ist, und ein Verbinden der Verbindungspartner mittels Löt-, Klebe- oder Niedertemperaturverbindungstechnik erfolgt; und eine auf diese Weise hergestellte Verbindung.

## Beschreibung

Die Erfindung betrifft ein Verfahren zum Erstellen einer rissarmen Verbindung, insbesondere einer solchen, die unter Temperaturwechseln zu Versprödung neigt.

Bei der Verbindung von Substraten (z.B. DCBs) von Leistungshalbleiterelektronik zu Wärmesenkenplatten werden bisher die Leistungsmodule durch Lötungen thermisch gut leitend dauerhaft verbunden. Lötungen leiden jedoch bei Temperaturwechsel unter zunehmender Versprödung, so dass nach einer Anzahl von Temperaturwechseln Risse in der Lotschicht entstehen, die die Wärmeabfuhr der Leistungsbauelemente verhindern. Als Folge tritt eine zerstörende Überhitzung ein, wobei der Vorgang dadurch, dass schon bei kleinen Teilbereichen, in denen sich Risse gebildet haben, die Temperaturabfuhr abnimmt, und durch ansteigende Temperaturen noch stärkere Lastwechsel entstehen.

Zu nennen ist zunächst die EP 1 387 609 A2, in der bereits - allerdings nur zur besseren thermischen Kontaktierung und "Wärmeaufspreizung" an ein leichtgewichtiges Kühlkörpermaterial - eine Kupferschicht auf den Kühlkörper durch Hochgeschwindigkeits-Flamm-Spritzen aufgebracht wird.

Aus der US 2003/0175559 A1 ist bereits ein Verfahren bekannt, ein Wärmesenkenlaminat aus einer Mischung von einem Metall und einer Keramik aufzuspritzen. Dabei wird insbesondere vorgeschlagen, eine Aluminum-Diamant-Metallmatrix zu erzeugen, und es wird auf gute Haftung der Schicht an seinem jeweiligen Substrat Wert gelegt. Es wird jedoch nicht das Problem einer Verbindung zweier Verbindungspartner angesprochen, die thermischen Lastwechseln ausgesetzt sind, wobei durch die Lastwechsel die Verbindung altert. Es wird lediglich ein bisher bekanntes Laminat vorgeschlagen, in einzelne Schichten durch Schichten dielektrischen kaltgespritzten Materials ersetzt werden.

Weiter ist aus der DE 100 65 495 C2 bereits ein Leistungshalbleitermodul bekannt, das eine Zentriereinrichtung aufweist, die es erlaubt, einen Druck zur Erzeilung einer stoffbündigen (thermischen) Verbindung aufzubringen. Dabei werden neben den Nachteilen, die eine weitere Schicht, z.B. ein Molybdänkörper mit sich bringt, die Nachteile dreier Verbindungsverfahren nach dem Stand der Technik erwähnt, nämlich das Verbinden der Teile mittels Löt-, Klebe- oder Niedertemperaturverbindungstechnik.

In allen genannten Druckschriften wird nicht das Problem einer Verbindung zweier Verbindungspartner angesprochen, die thermischen Lastwechseln ausgesetzt sind, wobei durch die Lastwechsel die Verbindung altert. Es wird allenfalls, so die DE 100 65 495 C2, ein bisher bekanntes Verbinden durch bessere Zentriermittel, z.B. Nasen an einer Zentriereinrichtung, allgemein optimiert.

Keines der Verfahren erlaubt es, eine ausreichend lange Lebensdauer dadurch zu erreichen, daß das Bauteil gegen aktive und passive Temperaturwechsel "gehärtet" wird.

Die Erfindung hat sich zur Aufgabe gesetzt, eine derartige Temperaturwechselfestigkeit zu erreichen.

Bisher wird durch besonders elastische Lotlegierungen oder Optimieren der Lotschichtdicke versucht, dem Problem zu begegnen. Beides kann jedoch bisher das Problem nicht völlig lösen.

Die Erfindung hat einen anderen Weg beschritten, der die Merkmale der unabhängigen Ansprüche wiedergegeben wird.

Insbesondere ist vorteilhaft, dass durch die Einführung einer weiteren, bisher nicht vorgesehenen Schicht aus einem Material mit einem thermischen Ausdehnungskoeffizienten, der zwischen denjenigen der jeweiligen Lotpartner gewählt ist, es möglich wird, auch für den Fall, dass die Verbindungstechnik keine weitere Verbindungsschicht wie Kleber oder Lot aufweist, die durch die thermische Ausdehnung bewirkten Ausdehnungsdifferenzen an jeder Grenzfläche des Lotpartners zu minimieren.

Die Dicke der Zwischenschicht wird dabei so zu bemessen sein, dass sie die sich einstellenden mechanischen Spannungen beim Temperaturwechsel aufnehmen kann, wobei die Größe der verbleibenden Ausdehnungskoeffizienten unterschiede zu berücksichtigen sind. Größere Unterschiede erfordern größere Schichtdicken, als geringe Unterschiede, ebenso wie größere Temperaturdifferenzen größere Schichtdicken erfordern.

Die wachsende Dicke wird dabei in der Praxis durch das Erfordernis der Wärmeabfuhr begrenzt, d. h. besser wärmeableitende Substanzen können in größere Schichtdicke verwandt werden.

Vorzugsweise wird jeweils der Mittelwert des thermischen Ausdehnungskoeffizienten verwendet, jedoch kann von diesem abgewichen werden, wenn ein anderes Material sich durch eine besonders hohe Wärmeleitfähigkeit auszeichnet. In diesem Fall kann mit einer höheren Schichtdicke gearbeitet werden, ohne dass es dabei einseitig zu Ablösungen können würde.

Schließlich kann die Zwischenschicht durch Lötung aufgebracht werden, in einer besonders bevorzugten Ausführungsform der Erfindung wird diese jedoch mit dem Gasdynamischen Pulverbeschichten, dem "Kaltgasspritzen") aufgebracht.

Bei diesem Verfahren, bei dem kleine Partikel eines im wesentlichen beliebigen Materials z. B. einer Lotlegierung oder auch elementarem Kupfer, Nickel, Eisen oder dergleichen, in einem Strom heißen Gases auf Teilbereiche des zu beschichtenden Gebietes aufgeschleudert werden, wird durch die hohen Geschwindigkeiten von beispielsweise über 600 m pro Sekunde beim Auftreffen der Partikel ein Aufschmelzen erfolgen, der sie innig mit der Substratschicht, einem der Lötpartner verschmelzen läßt, und somit eine stoffschlüssige Verbindung herstellt.

Da die Kügelchen klein sind, kann die Energiemenge jeweils nach dem Aufschmelzen auch schnell wieder abgeleitet werden, so dass der Auftrag am Ort verbleibt und nicht mit einer gesamten Schmelze am Ort zu rechnen ist.

Beispielsweise lassen sich Zwischenschichten aus folgenden Materialien erstellen: AlSIC (7-10 ppm/pro K), Nickel, CuW, Al₂O₃, SiC, Si₃Ni₄, Aluminium, Eisen, Kovar (eine Eisen-Nickel-Legierung), CuMo, AlN oder Beryllia (Berylliumoxid). Damit lassen sich insbesondere die Ausdehnungs-Unterschiede zwischen Bodenplatten aus Kupfer oder Aluminium zu denen der Substrate aus Al₂O₃, oder Siliziumnitrid Si₃Ni₄ oder AlN, Aluminiumnitrid ausgleichen.

Das erfindungsgemäße Verfahren zum Herstellen einer rißarmen Verbindung zwischen zwei Verbindungspartnern unterschiedlicher thermischen Ausdehnungskoeffizienten insbesondere für Leistungshalbleiter und deren Bestandteile, zeichnet sich dadurch aus, daß zum Aufspritzen unterschiedlichste Partikeln, wenigstens eines Materials, genutzt werden können. Das Material kann sowohl als legiertes Pulver als auch als gemischtes Pulver (Mikrolegierung) aufgebracht werden. Es kann sogar beim Aufspritzen die Zusammensetzung langsam variiert werden, so daß sich gemischte Gemenge und Legierungen bilden. Der sich bildende Gradient zeigt in Richtung des Gefälles zwischen den Ausdehnungskoeffizienten der verschiedenen Partner,

Dabei werden in einem Strom heißen Gases auf wenigstens Teilbereiche des zur Verbindung bestimmten Gebietes auf wenigstens einem der Verbindungspartner Schichten erzeugt, die innig mit dem einen Verbindungspartner verbunden sind und einen vorbestimmten thermischen Ausdehnungskoeffizienten besitzen, der zwischen den thermischen Ausdehnungskoeffizienten der Verbindungspartner gewählt ist, wodurch die schließlich erfolgende Löt- oder Klebverbindung rißarm wird.

Zum Verbinden kann eine weitere, auf der in einem ersten Schritt aufgespritzten Schicht aufgetragene Lötmassenschicht aufgebracht werden, wobei die im ersten Schritt aufgespritzte Schicht einen vorbestimmten thermischen Ausdehnungskoeffizienten besitzt, der zwischen den thermischen Ausdehnungskoeffizienten der Wärmesenke und dem als Substrat der aufgespritzten Schicht dienenden Verbindungspartner gewählt ist, oder es können die zum Aufspritzen genutzten Partikel aus einer Lötmasse bestehen, die den vorbestimmten thermischen Ausdehnungskoeffizienten aufweist, wobei das Verbinden ein Löten ist.

Neben einem Löten kommt Kleben oder eine sog. Niedertemperaturverbindungstechnik (NTV) in Frage, bei der durch Aufbringen von z.B. Silberpulvern mit Submikro-Strukturen und Verpressen eine Diffusion der Silberschichten erfolgt. In letzterem sinterähnlichen Prozeß mit Drücken von einigen zehn MPa entsteht keine flüssige Phase, so daß derartige Verbindungen hochtemperaturbelastbar sind (weit über 300° C).

In die Lötmasse können weiter in einer besonderen Variante des Verfahrens Partikel einer weiteren Substanz mit verbessertem Wärmeübertragungsvermögen mit eingespritzt werden.

Aber auch Klebeverbindungen lassen sich rißarmer gestalten, wobei Kleber auf den zweiten Verbindungspartner und/oder die aufgespritzte Schicht auf dem ersten Verbindungspartner aufgetragen wird und die letztliche Verbindung eine Klebeverbindung ist.

Bei großen Unterschieden der thermischen Dehnung zwischen Substrat und Wärmesenkenplatte besteht auch die Möglich durch zwei oder mehr Zwischenschichten den thermisch-mechanischen Stress der Einzelschichten und der Verbindungsschicht zu verringern. Zum Beispiel besitzt eine typische Wärmesenkenplatte aus Aluminium eine thermische Dehnung von ca. 24 ppm/K und eine sehr gut leitende Substratplatte die thermische Dehnung von nur 4 ppm/K. Dieser große Dehnungsunterschied wäre vorteilhaft durch mindestens zwei Zwischenschichten aus zum Beispiel Kupfer (18 ppm/K) und zum Beispiel Ni (13 ppm/K) und gegebenenfalls durch AISiC (8 ppm/K) für jede Schicht zu minimieren. Besonders vorteilhaft ist hier die Tatsache, dass jede der 3 beispielhaften Schichten durch das Kaltgasspritzen auf der jeweils unteren Schicht ohne weitere Verbindung haftet und eine stoffschlüssige (=gut wärmeleitende) Verbindung darstellt. Auf der dehnungsärmsten Schicht des Stapels (hier: AISiC) könnte dann durch Kleben, Löten oder Niedertemperatur-Verbinden das Substrat aus AIN gefügt werden.

## Patentansprüche

1. Verfahren zum Erstellen einer rißarmen, temperaturwechselfesten Verbindung zwischen zwei Verbindungspartnern unterschiedlicher thermischen Ausdehnungskoeffizienten nämlich Leistungshalbleitersubstraten und Wärmesenkenplatten mit einer in einem Strom heißen Gases aufgespritzten Schicht,
wobei das Aufspritzen von eine Verbindungsschicht bildendenden Partikeln auf wenigstens Teilbereiche des zur Verbindung bestimmten Gebietes auf wenigstens einen der Verbindungspartner unter Ausbildung wenigstens einer innig mit dem einen Verbindungspartner verbunden Schicht erfolgt,
wobei das Schichtmaterial einen vorbestimmten thermischen Ausdehnungskoeffizienten erhält, der zwischen den thermischen Ausdehnungskoeffizienten der Verbindungspartner gewählt ist, und
ein Verbinden der Verbindungspartner mittels Löt-, Klebe- oder Niedertemperaturverbindungstechnik erfolgt.

2. Verfahren nach Anspruch 1, **dadurch gekennzeichnet, daß** die eine Verbindungsschicht bildendenden Partikeln aus einem Material der Gruppe AISiC, Ni, Cu, CuW, Al, AlN, Eisen, Kovar oder CuMo gewählt sind

3. Verfahren nach einem der vorangehenden Ansprüche, **dadurch gekennzeichnet, daß** das Aufspritzen der Schicht auf den ersten Verbindungspartner nämlich Leistungshalbleitersubstraten und Wärmesenkenplatten mit langsam sich variierender Zusammensetzung eines Pulvers zur Erzeugung einer Legierung oder eines Gemisches des Schichtmaterials mit einem Gradienten in Richtung des Gefälles der Ausdehnungskoeffizienten der Verbindungspartner erfolgt.

4. Rißarme temperaturwechselfeste Verbindung zweier Verbindungspartner unterschiedlicher thermischen Ausdehnungskoeffizienten mit einer in einem Strom heißen Gases aufgespritzten Schicht, wobei die Schicht aus auf wenigstens Teilbereichen des ersten Verbindungspartners aufspritzten Partikeln aus einem Material besteht, das innerhalb des zur Verbindung bestimmten Gebietes auf dem ersten Verbindungspartner innig mit diesem einen verbunden ist, wobei das Material der Schicht einen vorbestimmten thermischen Ausdehnungskoeffizienten aufweist, der zwischen den thermischen Ausdehnungskoeffizienten der Verbindungspartner gewählt ist, und ein Verbinden der Verbindungspartner mittels Löt-, Klebe- oder Niedertemperaturverbindungstechnik zwischen der aufgespritzten Schicht und dem zweiten Verbindungspartner erfolgt.

5. Verbindung nach Anspruch 4, **dadurch gekennzeichnet, daß** die Schicht mit einem Ausdehnungskoeffizienten gewählt ist, so daß sich ein Gradient in Richtung des Gefälles der Ausdehnungskeffizieten der Verbindungspartner einstellt.

## Geänderte Patentansprüche

### Geänderte Patentansprüche gemäss Regel 86(2) EPÜ.

**1.** Verfahren zum Aufbau einer oder mehrerer thermisch-mechanischen Streß verringernden(-der) Zwischenschicht(en)¹ für eine rißarme, temperaturwechselfeste Verbindung in einem vorbestimmten Gebiet zwischen Leistungshalbleitersubstraten und Wärmesenkenplatten, die als Verbindungspartner unterschiedliche thermische Ausdehnungskoeffizienten aufweisen,
mit einem Aufspritzen einer in einem Strom heißen Gases aufgespritzten Zwischenschicht aus Partikeln, die eine Zwischenschicht bilden,
- auf wenigstens Teilbereiche des zur Verbindung bestimmten Gebietes,
- auf wenigstens einen der Verbindungspartner unter Ausbildung wenigstens einer innig mit dem einen Verbindungspartner verbunden Schicht,
wobei das Schichtmaterial einer jeden Zwischenschicht einen vorbestimmten thermischen Ausdehnungskoeffizienten erhält, der zwischen den thermischen Ausdehnungskoeffizienten der Verbindungspartner gewählt ist, und
ein wobei das Verbinden der Verbindungspartner mittels Löt-, Klebe- oder Niedertemperaturverbindungstechnik erfolgt.
¹ Seite 5, vierter Absatz, erster Satz der ursprünglichen Beschreibung

**2.** Verfahren nach Anspruch 1, **dadurch gekennzeichnet, daß** die eine Verbindungsschicht bildendenden Partikeln aus einem Material der Gruppe Al-SiC, Ni, Cu, CuW, Al, AlN, Eisen, Kovar oder CuMo gewählt sind

**3.** Verfahren nach einem der vorangehenden Ansprüche, **dadurch gekennzeichnet, daß** das Aufspritzen der Schicht auf den ersten Verbindungspartner nämlich Leistungshalbleitersubstraten und Wärmesenkenplatten mit langsam sich variierender Zusammensetzung eines Pulvers zur Erzeugung einer Legierung oder eines Gemisches des Schichtmaterials mit einem Gradienten in Richtung des Gefälles der Ausdehnungskoeffizienten der Verbindungspartner erfolgt.

**4.** Rißarme temperaturwechselfeste Verbindung zweier Verbindungspartner unterschiedlicher thermischen Ausdehnungskoeffizienten mit einer in einem Strom heißen Gases aufgespritzten Schicht, wobei die Schicht aus auf wenigstens Teilbereichen des ersten Verbindungspartners aufspritzten Partikeln aus einem Material besteht, das innerhalb des zur Verbindung bestimmten Gebietes auf dem ersten Verbindungspartner innig mit diesem einen verbunden ist, wobei das Material der Schicht einen vorbestimmten thermischen Ausdehnungskoeffizienten aufweist, der zwischen den thermischen Ausdehnungskoeffizienten der Verbindungspartner gewählt ist, und ein Verbinden der Verbindungspartner mittels Löt-, Klebe- oder Niedertemperaturverbindungstechnik zwischen der aufgespritzten Schicht und dem zweiten Verbindungspartner erfolgt.

**5.** Verbindung nach Anspruch 4, **dadurch gekennzeichnet, daß** die Schicht mit einem Ausdehnungskoeffizienten gewählt ist, so daß sich ein Gradient in Richtung des Gefälles der Ausdehnungskoeffizienten der Verbindungspartner einstellt.
